Europäisches Patentamt

European Patent Office

Office européen des brevets

(11) Veröffentlichungsnummer: **0 082 280**
**B1**

(12) # EUROPÄISCHE PATENTSCHRIFT

(45) Veröffentlichungstag der Patentschrift:
18.03.87

(21) Anmeldenummer: 82110201.9

(22) Anmeldetag: 05.11.82

(51) Int. Cl.⁴: **H 05 K 7/20**, H 04 B 1/036,
H 01 F 27/08, G 12 B 15/00

(54) **Kühlsystem für nachrichtentechnische Geräte hoher Verlustleistung.**

(30) Priorität: 18.12.81 DE 3150166

(43) Veröffentlichungstag der Anmeldung:
29.06.83 Patentblatt 83/26

(45) Bekanntmachung des Hinweises auf die Patenterteilung:
18.03.87 Patentblatt 87/12

(84) Benannte Vertragsstaaten:
BE DE FR GB IT LU NL

(56) Entgegenhaltungen:
AU-A-58 481
DE-A-2 209 938
DE-A-2 753 914
DE-B-1 191 901
DE-C-971 999
DE-C-2 712 017

(73) Patentinhaber: ANT Nachrichtentechnik GmbH,
Gerberstrasse 33, D-7150 Backnang (DE)

(72) Erfinder: Rauth, Erich, Ing. grad., Falkenweg 18,
D-7151 Auenwald (DE)
Erfinder: Form, Ernst, Ing. grad., Theodor- Heuss-
Strasse 51, D-7157 Sulzbach (DE)

(74) Vertreter: Schickle, Gerhard, Dipl.- Ing., ANT
Nachrichtentechnik GmbH Patent- und
Lizenzabteilung Gerberstrasse 33, D-7150
Backnang (DE)

### Beschreibung

Die Erfindung betrifft ein Kühlsystem für nachrichtentechnische Geräte hoher Verlustleistung gemäß dem Oberbegriff des Patentanspruchs 1. Ein solches Kühlsystem ist bekannt aus der DE-A 27 53 914. Das dortige Kühlsystem eignet sich jedoch nicht zur Abfuhr größerer Wärmemengen.

Aus der AU-A 58 481/69 ist ein Kühlsystem bekannt, welches ebenfalls Verlustwärme elektrischer Geräte an das umgebende Erdreich abführt. Zum Schutz gegen Umwelteinflüsse sind die elektrotechnischen Geräte hoher Verlustleistung in einem geschlossenen Behälter untergebracht. Der Behälter besteht aus gut wärmeleitendem Material und ist derart mit dem ihn umgebenden Erdreich verbunden, daß eine gute Wärmeleitung zustande kommt. An der Außenwand des Behälters ist ein Wärmetauscher vorgesehen. Ein zweiter Wärmetauscher ist beim Ausführungsbeispiel gemäß Figur 8 über ein Rohrleitungssystem an den ersten Wärmetauscher angeschlossen. Ein Kühlmittelkreislauf durch das Rohrleitungssystem kommt dort nur mittels des zweiten Wärmetauschers zustande. Das Rohrleitungssystem muß wärmeisolierend ausgebildet sein und mit einer bestimmten Neigung verlegt sein, damit über den zweiten Wärmetauscher Wärme an das umgebende Erdreich abgegeben werden kann.

Die Wärmeabgabe beim Ausführungsbeispiel gemäß Fig. 8 der AU-A 58 481/69 wird nicht sehr effektiv sein können, da sich die Zuleitungsrohre des Rohrleitungssystems in einem Nebenkreislauf bezüglich des Kühlmittelhauptkreislaufs in dem an der Außenwand des Behälters angeordneten Wärmetauscher befinden.

Aus der DE-B 11 91 901 ist es prinzipiell bekannt, bei einem Kühlsystem für elektrotechnische Geräte Peltier-Elemente als Wärmeleitungsbrücken vorzusehen.

Aus der DE-B 27 72 017 ist ein Kühlsystem bekannt, bei dem Abwärme an ein Rohrleitungssystem außerhalb des Behälters für die nachrichtentechnischen Geräte abgeführt wird. Der Flüssigkeitskreislauf im Rohrleitungssystem kommt dort allein durch Temperatur- und Dichteunterschiede zustande. Dieses Kühlsystem weist jedoch ein gegen die Umgebung isoliertes Gehäuse auf.

Bei dem kombinierten Kühl-Heizsystem der DE-PS 27 12 017 sollen Temperaturschwankungen zwischen Tag und Nacht ausgeglichen werden. Die am Tage auftretende Wärme wird gespeichert und in der Nacht abgegeben. Zur dauernden Abführung großer Wärmemengen ist dieses kombinierte Kühl-Heizsystem nicht geeignet.

Aufgabe der Erfindung ist es, das Kühlsystem gemäß dem Oberbegriff des Patentanspruchs 1 so auszubilden, daß ständig große Wärmemengen ohne aufwendige Zusatzeinrichtungen abgeführt werden können.

Diese Aufgabe wird durch die kennzeichnenden Merkmale des Patentanspruchs 1 gelöst.

In den Unteransprüchen sind vorteilhafte Ausbildungen der Erfindung angegeben.

Vorteile der Erfindung sind durch den sicheren und definierten Wärmeübergang gegeben, da eine Luftzirkulation zur Wärmeübertragung nicht nötig ist. Durch Abgabe eines Teiles der entstehenden Verlustwärme über die Behälterwand an das umgebende Erdreich können große Wärmemengen abgeführt werden. Zur Verlegung des Rohrleitungssystem können sowieso benötigte Kabelgräben verwendet werden.

Anhand der Zeichnungen wird die Erfindung nun näher erläutert. Dabei zeigt:

Fig. 1 ein an der Außenwand des Behälters angebrachtes Kühlsystem,

Fig. 2 einen Ausschnitt aus einem Kühlsystem, dessen Rohrleitungssystem teilweise innerhalb des Behälters verläuft,

Fig. 3 ein Kühlsystem mit senkrechten Rohren, die über Ringleitungen in Verbindung stehen.

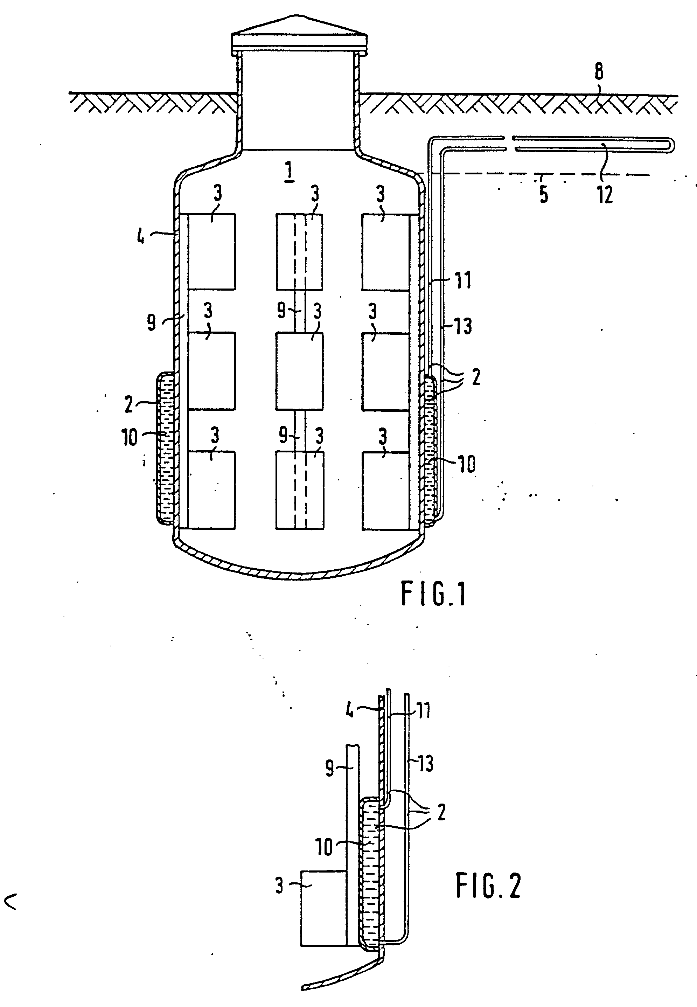

In Fig. 1 ist der Behälter 1 im Schnitt dargestellt. Nur die Einstiegsöffnung des Behälters 1 überragt das Erdreich 8. Der Behälter 1 dient zum mechanischen und feuchtigkeitsdichten Schutz der an wärmeleitenden Montageschienen 9 befestigten nachrichtentechnischen Geräte 3. Über Wärmeleitungsbrücken stehen die nachrichtentechnischen Geräte 3 sowohl mit dem Rohrleitungssystem 2 als auch mit der Wand 4 des Behälters 1 in Wärmekontakt. Die Verlustleistung der nachrichtentechnischen Geräte 3 wird also teilweise von der Behälterwand 4 aufgenommen, wie auch an die Flüssigkeit 10 innerhalb des Rohrleitungssystems 2 durch Wärmetausch abgegeben. Da der Behälter 1 vorzugsweise aus Stahl besteht ist die Behälterwand 4 gut wärmeleitend. Es erfolgt daher ein guter Wärmeübergang an das umgebende Erdreich. Vorzugsweise wird der Raum zwischen Behälter 1 und ausgehobenem Schacht mit Sand (Quarzsand) ausgefüllt, um eine gute Wärmeleitung zum ungestörten Erdreich (normale Erdreichtemperatur) zu gewährleisten.

Beim Ausführungsbeispiel von Fig. 1 ist im unteren Bereich des Behälters 1 an dessen Außenmantel ein manschettenartiges Gefäß als Wärmetauscher-Teil des Rohrleitungssystems 2 angebracht. Die darin befindliche Flüssigkeit 10 erwärmt sich unter der Einwirkung der Verlustwärme der nachrichtentechnischen Geräte 3.

Im oberen Bereich des manschettenartigen Gefäßes befindet sich der Anschluß für den Vorlauf und im unteren Bereich der Anschluß für den Rücklauf. Die erwärmte Flüssigkeit 10 steigt im Steigrohr 11, das im Bereich der Einstiegsöffnung umbiegt und in einer Rohrschlange 12 parallel zum Erdbodenniveau in einem Kabelgraben 5 verläuft. Die Kabelgrabenunterkante ist in Fig. 1 gestrichelt dargestellt. Die Rohrschlange 12 muß aus gut wärmeleitendem Material sein, damit ein guter Wärmetausch an das umgebende Erdreich stattfinden kann. Die Rohrschlangen 12 werden aus denselben Gründen wie der Behälter 1 in Sand eingebettet.

Das Ende der Rohrschlange 12 mündet in ein Fallrohr 13, das die abgekühlte Flüssigkeit 10 dem manschettenartigen Gefäß zuleitet. Es können auch mehrere manschettenartige Gefäße vorhanden sein, die durch Rohre miteinander verbunden sind. Ebenso können mehrere Rohrschlangen vorgesehen sein, beispielsweise in verschiedenen Kabelgräben, die außerdem ein vverzweigtes System bilden können.

Der Flüssigkeitsumlauf wird allein durch Temperatur und Dichteunterschiede aufrechterhalten. Abhängig ist dieser Freiumlauf von der Temperaturdifferenz $\Delta T$ zwischen ungestörtem Erdreich und der Vorlauftemperatur der Flüssigkeit 10. Diese Parameter sind im allgemeinen vorgegeben. Eine weitere Abhängigkeit ist durch die Höhendifferenz $\Delta h$ zwischen dem manschettenartigen Gefäß und den Rohrschlangen gegeben. Für den Freiumlauf müssen $\Delta T$ und $\Delta h$ derart gewählt werden, daß ein Umtriebsdruck entsteht, der den Strömungswiderstand im Rohrleitungssystem 2, der im wesentlichen durch die Rohrreibung und die Viskosität der Flüssigkeit 10 gegeben ist, überwindet.

Fig. 2 zeigt ein anderes Ausführungsbeispiel des erfindungsgemäßen Kühlsystems. Das manschettenartige Gefäß als Wärmetauscher-Teil des Rohrleitungssystems 2 ist ringförmig an der Innenseite der Behälterwand 4 angebracht. Die nachrichtentechnischen Geräte 3 stehen über Wärmebrücken mit den wärmeleitenden Montageschienen 9 in Verbindung, welche wiederum in Wärmekontakt zu dem manschettenartigen Gefäß stehen. Die übrigen Teile des Kühlsystems entsprechen denen von Fig. 1

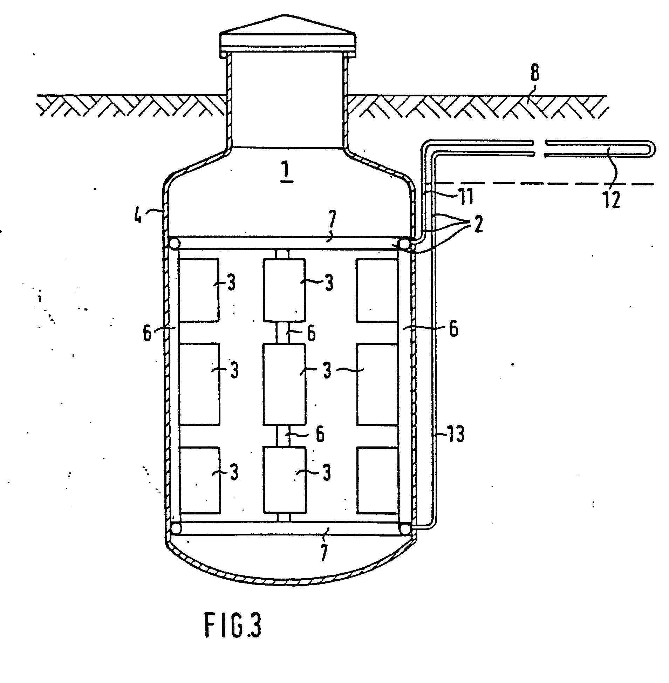

Ein weiteres Ausführungsbeispiel der Erfindung zeigt Fig. 3. Übereinander angeordnete nachrichtentechnische Geräte 3 sind hier jeweils an einem senkrechten Rohr 6, das einen Wärmetauscher-Teil des Kühlsystems bildet, wärmekontaktiert. Die senkrechten Rohre 6 münden an ihren Enden in Ringleitungen 7, die innerhalb oder außerhalb des Behälters 1 angebracht sein können

- in Fig. 3 verlaufen die Ringleitungen 7 innerhalb des Behälters 1. Die obere Ringleitung 7 ist mit dem Vorlauf verbunden, wohingegen die untere Ringleitung 7 mit dem Rücklauf in Verbindung steht. Die Funktion des Flüssigkeitskreislaufes ist dabei wie bei dem zuerst vorgestellten Ausführungsbeispiel.

Die Wärmeleitungsbrücken, d.h., die Wärmekontaktpunkte zwischen den nachrichtentechnischen Geräten 3 und den Schienen 9, bzw. Behälterwand 4 oder manschettenartigem Gefäß, können als Peltier-Elemente ausgebildet sein.

Als Flüssigkeit für den Kreislauf kann Wasser verwendet werden oder eine sonstige Flüssigkeit, die eine große Wärmekapazität und eine geringe Viskosität aufweist. Zum Schutz gegen Frost kann der Flüssigkeit ein Frostschutzmittel beigemischt werden.

**Patentansprüche**

1. Kühlsystem für nachrichtentechnische Geräte hoher Verlustleistung, die zum Schutz gegen Umwelteinflüsse in einem geschlossenen Behälter untergebracht sind, der aus gut wärmeleitendem Material besteht und derart mit dem ihn umgebenden Erdreich verbunden ist, daß eine gute Wärmeleitung vom Behälter zum Erdreich zustande kommt, wobei die nachrichtentechnischen Geräte mit der Wand des Behälters nur über Wärmeleitungsbrücken wärmeleitend verbunden sind, dadurch gekennzeichnet, daß zur zusätzlichen Kühlung der nachrichtentechnischan Geräte (3) ein mit Kühlflüssigkeit gefülltes Rohrleitungssystem (2) vorgesehen ist, dessen Flüssigkeitsumlauf allein infolge der Temperatur- und Dichteunterschiede zustande kommt, und daß das Rohrleitungssystem (2) aus einem mit den nachrichtentechnischen Geräten (3) nur über Wärmeleitungsbrücken wärmeleitend verbundenen Wärmetauscher-Teil, einem mit dem oberen Bereich des Wärmetauscher-Teils verbundenen Steigrohr (11), einem mit dem unteren Bereich des Wärmetauscher-Teils verbundenen Fallrohr (13) und einer das Steigrohr (11) und das Fallrohr (13) verbindenden, gut wärmeleitenden und im umgebenden Erdreich verlegten Rohrschlange (12) besteht.

2. Kühlsystem nach Anspruch 1, dadurch gekennzeichnet, daß das mit Kühlflüssigkeit gefüllte Rohrleitungssystem (2) in Kabelgräben (5) verlegt ist, die zur Aufnahme der Nachrichtenkabel zwischen den Behältern (1) für nachrichtentechnische Geräte sowieso vorhanden sind.

3. Kühlsystem nach Anspruch 1, dadurch gekennzeichnet, daß sämtliche Rohre des Rohrleitungssystems (2) außerhalb des gut wärmeleitenden Behälters (1) verlaufen.

4. Kühlsystem nach Anspruch 1, dadurch gekennzeichnet, daß der Wärmetauscher-Teil (6, 7) des Rohrleitungssystems (2) im gut wärmeleitenden Behälter (1) verläuft.

5. Kühlsystem nach Anspruch 3 oder 4, dadurch gekennzeichnet, daß übereinander angeordnete nachrichtentechnische Geräte (3) mit jeweils einem senkrechten Rohr (6) als Wärmetauscher-Teil des Rohrleitungssystems (2) über Wärmeleitungsbrücken in Verbindung stehen und daß diese senkrechten Rohre (6) an ihren Enden in Ringleitungen (7) münden.

6. Kühlsystem nach Anspruch 1 oder 2, dadurch gekennzeichnet, daß die Flüssigkeit in dem mit dem umgebenden Erdreich verbundenen Rohrleitungssystem (2) gut wärmeleitend ist und eine geringe Viskosität aufweist.

7. Kühlsystem nach Anspruch 6, dadurch gekennzeichnet, daß der Flüssigkeit ein Frostschutzmittel beigemischt ist.

8. Kühlsystem nach Anspruch 1 oder 5, dadurch gekennzeichnet, daß die Wärmeleitungsbrücken als Peltier-Elemente ausgebildet sind.

**Claims**

1. Cooling system for communications devices dissipating large amounts of energy and, as protection against environmental influences, being accommodated in a closed container which is made of a material having good heat conducting properties and is connected with the soil surrounding it in such a manner that good heat conduction is established from the container to the soil, with said communications devices being connected in a heat conducting manner with the wall of the container only through heat conduction bridges, characterized in that additional cooling is provided for the communications devices (3) by a pipeline system (2) filled with a coolant whose turnover is effected only as a result of differences in temperature and density and said pipeline system (2) is composed of a heat exchanger member connected with the communications devices (3) in a heat conducting manner only by way of heat conduction bridges, a riser pipe (11) connected with the upper region of the heat exchanger member, a down pipe (13) connected with the lower region of the heat exchanger member and a coiled pipe (12) connecting the riser pipe (11) and the down pipe (13), said pipe coil having good heat conducting properties and being installed in the surrounding soil.

2. Cooling system according to claim 1, characterized in that the pipeline system (2) filled with coolant is installed in cable ditches (5) provided in any case to accommodate the communications cables between the containers (1) for communications devices.

3. Cooling system according to claim 1, characterized in that all pipes of the pipeline system (2) extend outside the heat conducting container (1) having good heat conducting properties.

4. Cooling system according to claim 1, characterized in that the heat exchanger member (6, 7) of the pipeline system (2) extends in the container (1) having good heat conducting properties.

5. Cooling system according to claim 3 or 4, characterized in that communications devices (3) arranged one on top of the other are each in communication by way of heat conduction bridges with a vertical pipe (6) serving as the heat exchanger member of the pipeline system (2), with the ends of said vertical pipes (6) opening into annular conduits (7).

6. Cooling system according to claim 1 or 2, characterized in that the fluid in the pipeline system (2) connected with the surrounding soil has good heat conducting properties and low viscosity.

7. Cooling system according to claim 6, characterized in that an antifreeze agent is mixed with the fluid.

8. Cooling system according to claim 1 or 5, characterized in that the heat conduction bridges are configured as Peltier elements.

**Revendications**

1. Système de refroidissement pour appareils de télécommunication à grande puissance dissipée, qui, pour être protégés contre les influences ambiantes, sont logés dans une boite fermée constituée d'un matériau bon conducteur de la chaleur et reliée avec le sol qui l'entoure de façon telle qu'il se produise une bonne conduction thermique entre la boite et le sol, étant précisé que les appareils de télécommunication ne sont reliés, au point de vue conduction thermique, à la paroi de la boite que par l'intermédiaire de ponts de conduction thermique, caractérisé en ce que l'on prévoit pour le refroidissement supplémentaire des appareils de télécommunication (3) un système de conduites tubulaires (2) qui est rempli d'un liquide réfrigérant, la mise en circulation du liquide ne se réalisant que du fait des différences de température et de densité; et en ce que le système de conduites tubulaires (2) est constitué d'une partie formant échangeur thermique qui n'est relié, du point de vue conduction thermique, aux appareils de télécommunication (3) que par l'intermédiaire de ponts de conduction thermique, d'un tube montant (11) relié à la zone supérieure de la partie formant échangeur de chaleur, d'une descente tubulaire (13) reliée à la zone inférieure de la partie formant échangeur de chaleur et d'une boucle tubulaire (12) reliant le tube montant (11) et la descente tubulaire (13), bonne conductrice de la chaleur et posée dans le sol environnant.

2. Système de refroidissement selon la revendication 1, caractérisé en ce que l'on pose le système de conduites tubulaires (2), rempli du liquide de refroidissement, dans des fosses pour câbles (5) qui existent de toutes façons pour recevoir le câble de télécommunication entre les boites (1) pour appareils de télécommunication.

3. Système de refroidissement selon la revendication 1, caractérisé en ce que tous les tubes du système de conduites tubulaires (2) courent à l'extérieur de la boite (1) bonne conductrice de la chaleur.

4. Système de refroidissement selon la revendication 1, caractérisé en ce que la partie (6, 7) du système de conduites tubulaires (2) formant échangeur de chaleur court dans la boite (1) bonne conductrice de la chaleur.

5. Système de refroidissement selon la revendication 3 ou 4, caractérisé en ce que des appareils de télécommunication disposés l'un au-dessus de l'autre (3) sont respectivement reliés à un tube vertical (6) en tant que partie du système de conduites tubulaires (2) formant échangeur de chaleur, par l'intermédiaire de ponts de condition thermique; et en ce que ces tubes verticaux (6) débouchent à leurs extrémités dans des conduites annulaires (7).

6. Système de refroidissement selon la revendication 1 ou 2, caractérisé en ce que le liquide qui se trouve dans le système de conduites tubulaires (2) relié au sol environnant est bon conducteur de la chaleur et présente une faible viscosité.

7. Système de refroidissement selon la revendication 6, caractérisé en ce que l'on ajoute au liquide un antigel.

8. Système de refroidissement selon la revendication 1 ou 5, caractérisé en ce que les ponts de conduction thermique sont conçus sous forme d'éléments Peltier.

FIG.1

FIG.2

FIG.3